# EUROPEAN PATENT SPECIFICATION

(11) **EP 4 365 798 B1**
(45) Date of publication and mention of the grant of the patent: **09.07.2025**
(21) Application number: 23198764.5
(22) Date of filing: 21.09.2023
(51) Int. Cl.: G06Q 10/0832, F25D 31/00, F25D 3/06, F25D 3/12

(54) **DELIVERY SUPPORT METHOD, DELIVERY SUPPORT SYSTEM, AND DELIVERY SUPPORT PROGRAM**
LIEFERUNTERSTÜTZUNGSVERFAHREN, LIEFERUNTERSTÜTZUNGSSYSTEM UND LIEFERUNTERSTÜTZUNGSPROGRAMM
PROCÉDÉ DE SUPPORT DE DISTRIBUTION, SYSTÈME DE SUPPORT DE DISTRIBUTION ET PROGRAMME DE SUPPORT DE DISTRIBUTION

(30) Priority: 03.11.2022 JP 2022176814
(43) Date of publication of application: 08.05.2024
(73) Proprietor: DENSO CORPORATION, Kariya-city, Aichi-pref. 448-8661 (JP)
(72) Inventor: TSUBOI, Soichiro, Kariya-city, Aichi-pref.,, 448-8661 (JP); MAEDA, Fumitsugu, Kariya-city, Aichi-pref.,, 448-8661 (JP)
(74) Representative: Winter, Brandl - Partnerschaft mbB

(56) References cited:
- US-A1- 2020 057 989
- US-A1- 2020 342 560
- US-A1- 2021 101 745
- US-A1- 2022 237 560

## Description

### TECHNICAL FIELD

The present invention relates to a delivery support technology to support a process for delivery of articles by a delivery vehicle.

### BACKGROUND

Patent Literature 1 discloses a technique of combining a cold storage box, a cold storage material, and dry ice in order to cool and transport articles such as refrigerated articles and frozen articles.

Patent Literature 1: JP 2007-45519 A

Document US 2021 / 101 745 A1 discloses an adjustable, temperature-controlled receiving tunnel for receiving after-hours delivery of pallets or other items and/or providing temporary overflow storage of items. The receiving tunnel includes a set of cooling units and drop-down bulkheads creating temperature-controlled storage zones within the receiving tunnel. A guidance system provides instructions to a delivery truck driver connecting to the receiving tunnel. An extension device enables the tunnel to connect to a delivery truck which is unaligned with the end of the receiving tunnel. An autonomous pallet jack can autonomously move pallets from the delivery truck storage area into the interior of the receiving tunnel. A set of doors associated with the receiving tunnel can be locked or unlocked providing a pass-through tunnel into a receiving facility storage area for transport of pallets from the delivery truck into the storage area of the receiving facility. A temperature manager component analyses dynamic track delivery data and ambient temperature data to generate a cooling initiation time and a predicted cooling time needed to reach, after the cooling initiation time, a target temperature for a set of pallets within a selected zone in a set of temperature-controlled zones within an interior compartment within a main body of the receiving tunnel.

Document US 2022 / 237 560 A1 discloses a delivery plan creating system that includes: a stowage rule generation unit that generates stowage rules using delivery performance data including records of a type of a delivery vehicle and a type of a package to be delivered by the delivery vehicle and stores the stowage rules in a stowage rule storage unit; a delivery plan calculation unit that estimates a scheme of the package to be loaded on the delivery vehicle and creates a delivery plan using the scheme when the package to be loaded on each delivery vehicle in the scheme matches one of the stowage rules; and a display unit that displays the delivery plan.

Document US 2020 / 057 989 A1 discloses temperature pack cooling systems and methods of controlling product temperatures during delivery. The system comprises a plurality of insulations; a plurality of temperature packs; a product delivery control circuit that obtains an identification of each of multiple products to be transported; obtains transport temperature thresholds corresponding to one of the multiple products; obtains transport parameters comprising a predicted transport duration and expected environmental conditions; determines quantities of insulation to be positioned at each of multiple different insulation locations about the multiple products and number of temperature packs to be positioned at cooling locations about the multiple products; and determines an ordered arrangement of each of the multiple products relative to the temperature threshold of each of the multiple products, the insulation locations and the cooling locations.

Document US 2020 / 342 560 A1 discloses a transportation planning apparatus that calculates work time included in a transportation work plan. The transportation planning apparatus holds (i) order information showing a plurality of orders each including a delivery work and a pickup work, a site where the delivery work is performed, and a site where the pickup work is performed, and (ii) work time information of the delivery work, the pickup work, and a delivery and pickup work when regarded as one work. A transportation work order plan is generated showing a performing order of the delivery work and the pickup work that are included in the plurality of orders, sets the delivery work and the pickup work that are continuous at the same site, and specifies work time of the delivery work, the pickup work, and the delivery and pickup work that are included in the transportation work order plan with reference to the work time information.

### SUMMARY

However, the technique disclosed in Patent Literature 1 merely exemplifies the arrangement of articles in the cooling box. The arrangement form in the cooling box has to be left to the experience value of the operator, and there is a concern that the cooling power necessary for the transport destination cannot be secured. In general, in the delivery process in which the transport destination is a general consumer, since the delivery vehicle is not necessarily an expensive cold storage vehicle, it is expected that the cold storage capacity can be finely adjusted in accordance with the delivery conditions. In the technology disclosed in Patent Literature 1, since the cold insulation box, the cold storage material, and the dry ice are assumed to be disposable, improvement is also required from the viewpoint of the circular economy.

An object of the present invention is to provide a delivery support method, a delivery support system, and a delivery support program that each secure a cooling power necessary for delivery. The object is solved by the features of the independent claims. The dependent claims are directed to preferred embodiments of the invention.

Hereinafter, technical means of the present invention for solving the issues will be described. Note that the reference numerals indicate the corresponding relationship with the specific means described in the embodiments described in detail later, and do not limit the technical scope of the present invention.

According to the present invention, the cold insulation analysis model is read from the storage medium to analyze the cooling time according to the arrangement pattern of the articles in the delivery box. Therefore, the optimum data obtained by optimizing the cooling time and the arrangement pattern is output by the cold insulation analysis model to which the delivery conditions of the articles are input. Accordingly, since the cooling time and the arrangement pattern that influence the cooling power can be determined based on the output optimum data, it is possible to secure the cooling power necessary for the delivery.

### BRIEF DESCRIPTION OF THE DRAWINGS

FIG. 1 is a schematic diagram illustrating an overall configuration of an embodiment.
FIG. 2 is a block diagram illustrating a physical configuration of a delivery support system of the embodiment.
FIG. 3 is a block diagram illustrating a functional configuration of a delivery support system of the embodiment.
FIG. 4 is a flowchart illustrating a delivery support flow of the embodiment.
FIG. 5 is a schematic diagram for explaining a delivery support flow of the embodiment.
FIG. 6 is a block chart for explaining a cold insulation analysis model of the embodiment.
FIG. 7 is a characteristic table for explaining a cold insulation analysis model of the embodiment.
FIG. 8 is a schematic diagram illustrating a delivery support flow of the embodiment.
FIG. 9 is a block diagram illustrating an optimization subroutine of the embodiment.
FIG. 10 is a graph illustrating an optimization subroutine of the embodiment.
FIG. 11 is a schematic diagram illustrating an optimization subroutine of the embodiment.
FIG. 12 is a block chart illustrating an optimization subroutine according to a modification of the embodiment.

### DESCRIPTION OF EMBODIMENT

Hereinafter, an embodiment of the present invention will be described with reference to the drawings.

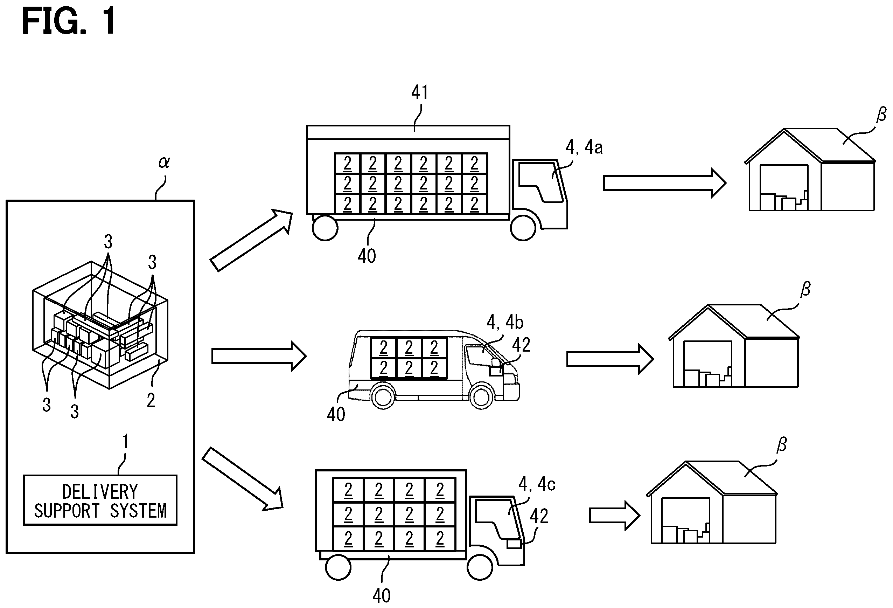

A delivery support system 1 according to an embodiment illustrated in FIG. 1 supports a delivery process by a delivery vehicle 4 for articles 3 that requires cooling in a delivery box 2. At least a part of the delivery support system 1 is installed in a management station α such as a picking station that manages packing of the articles 3 into the delivery box 2. The operator related to the delivery support system 1 may be the same as or different from the packing worker, for example, when the worker who packs the articles 3 into the delivery box 2 is working in the management station α.

The article 3 to be subjected to the delivery process by the delivery vehicle 4 is at least one type of food that needs to be kept cold, among, for example, a refrigerated product, a frozen product, and a room temperature preservation product. The article 3 may include at least one type of packaging article for packaging such food, for example, a polystyrene foam container, a plastic container, a plastic film, or the like. The article 3 may include at least one of, for example, a medicine, a feed, a solvent, a solution, miscellaneous goods, a building material, an electronic device, and the like that need to be kept cold other than foods. The delivery box 2 capable of packaging one or more articles 3 is, for example, at least one of a cardboard box, a plastic case, a polystyrene foam box, and the like.

The delivery vehicle 4 that delivers the articles 3 packed in one or more delivery boxes 2 may be, for example, a cold storage vehicle 4a equipped with a cargo bed 40 capable of cooling the articles 3 to a set temperature or lower by a cooling dedicated unit 41 such as a cold storage container. The delivery vehicle 4 may be a cargo van 4b that is not equipped with the cooling dedicated unit 41 and is equipped with a cargo bed 40 on which the article 3 is placed in a vehicle interior that can be air-conditioned by an air conditioning unit 42 such as an air conditioner. The delivery vehicle 4 may be a cargo truck 4c that is not equipped with the cooling dedicated unit 41 and is equipped with a cargo bed 40 on which the article 3 is placed in a cargo compartment isolated from air conditioning by the air conditioning unit 42 for the cabin. The delivery vehicle 4 may be other than the cold storage vehicle 4a, the cargo van 4b, and the cargo truck 4c.

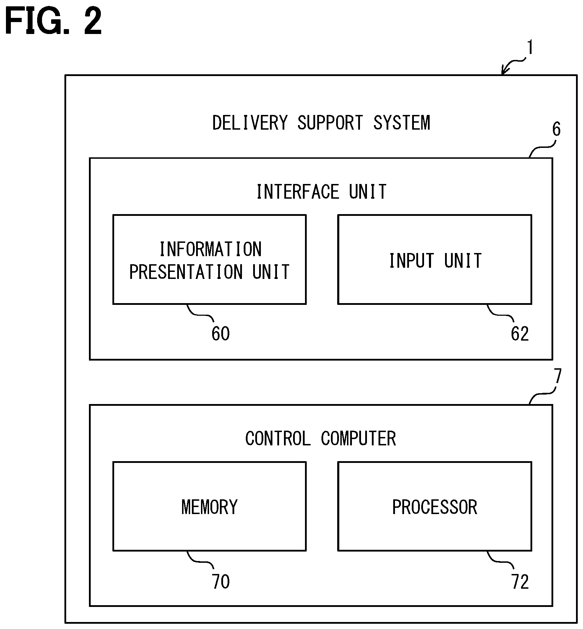

As shown in FIG. 2, the delivery support system 1 includes an interface unit 6. The interface unit 6 is at least one of, for example, an information presentation unit 60 or/and an input unit 62 installed in the management station α. FIG. 2 illustrates an example of the delivery support system 1 including both the information presentation unit 60 and the input unit 62.

The information presentation unit 60 presents information to the operator of the delivery support system 1. The information presentation unit 60 is, for example, at least one of a liquid crystal panel, an organic EL panel, and the like that displays an image of data necessary for supporting the delivery process. The information presentation unit 60 may include, for example, a speaker or the like that outputs data necessary for supporting the delivery process by voice.

The input unit 62 is, for example, at least one of a mouse, a trackball, a keyboard, and the like that receives an input from the operator. The input unit 62 may be configured to provide a graphical user interface (GUI) to the operator in cooperation with the information presentation unit 60.

The delivery support system 1 further includes one or more control computers 7 as dedicated computer in order to control the interface unit 6 to support the delivery process by the delivery support system 1. The control computer 7 may be installed in the management station α. The control computer 7 may be installed outside the management station α as at least one of a cloud server, an edge server, and the like. The control computer 7 is connected to the interface unit 6 via at least one of, for example, a local area network (LAN) line, a wire harness, an internal bus, and a wireless communication line. When there are plural control computers 7 constituting the delivery support system 1, the connection between the control computers 7 is the same as described.

The control computer 7 includes a memory 70 and a processor 72. The memory 70 is at least one type of non-transitory tangible storage medium among, for example, a semiconductor memory, a magnetic medium, an optical medium, and the like that non-temporarily stores a computer-readable program, data, a model, and the like. The processor 72 includes at least one of the CPU, GPU, and RISC-CPU as a core.

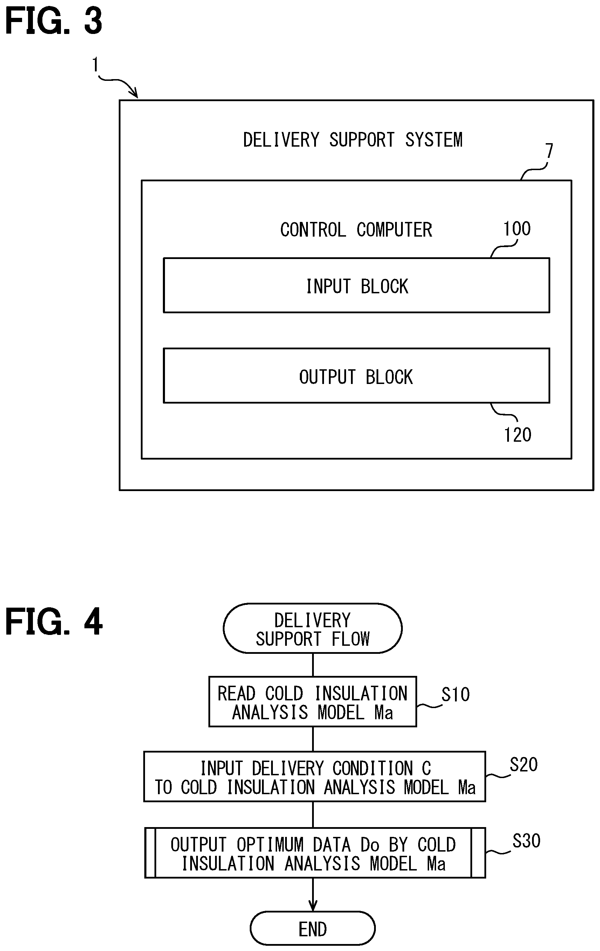

In the control computer 7, the processor 72 executes plural instructions included in the delivery support program stored in the memory 70 in order to support the delivery process by the delivery support system 1. Accordingly, the control computer 7 constructs plural functional blocks for supporting the delivery process by the delivery support system 1 in cooperation with the memory 70. As shown in FIG. 3, the functional blocks constructed in the control computer 7 include an input block 100 and an output block 120.

The input block 100 and the output block 120 execute a delivery support method for supporting the delivery process by the delivery support system 1 according to the delivery support flow illustrated in FIG. 4. The delivery support flow is executed in response to a command from an operator of the delivery support system 1 or automatically and repeatedly during activation of the delivery support system 1. Each "S" in the delivery support flow means each of steps executed by the instructions included in the delivery support program.

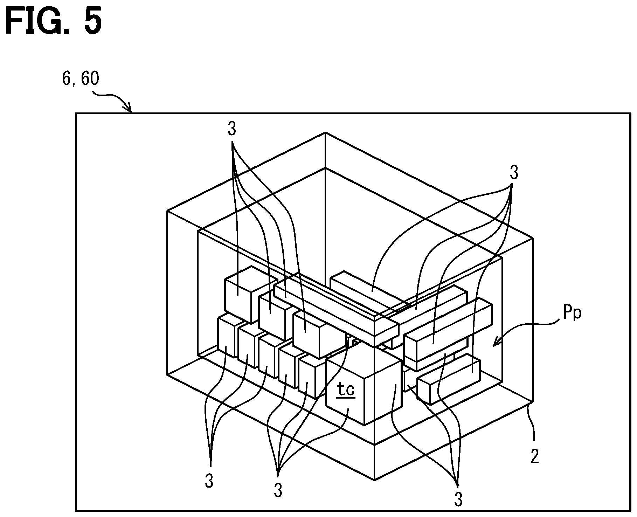

In S10 of the delivery support flow, the input block 100 reads the cold insulation analysis model Ma from the memory 70. Specifically, as illustrated in FIG. 5, the cold insulation analysis model Ma is constructed by, for example, a simulation model, a statistical model, a machine learning model, or the like in order to analyze the cooling time tc corresponding to the arrangement pattern Pp representing the three-dimensional arrangement position of the articles 3 in the delivery box 2. The articles 3 in the delivery box 2 illustrated in FIG. 5 and FIG. 1 are schematically illustrated by a rectangular parallelepiped for convenience of description.

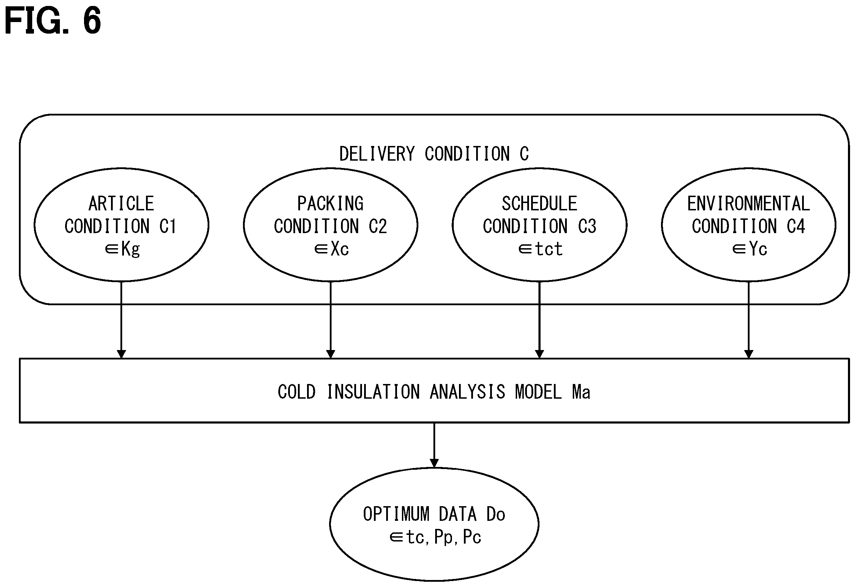

The cold insulation analysis model Ma is configured to output the optimum data Do in which the cooling time tc and the arrangement pattern Pp are optimized by using the delivery condition C illustrated in FIG. 6 as an input condition. Further, the cold insulation analysis model Ma of the present embodiment can output the optimum data Do obtained by optimizing the cooling pattern Pc in the delivery vehicle 4 together with the cooling time tc and the arrangement pattern Pp.

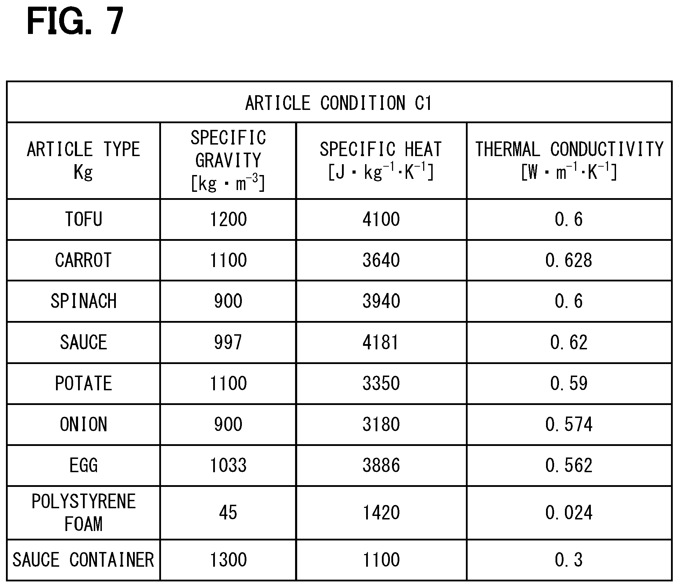

The delivery condition C input to the cold storage analysis model Ma includes an article condition C1, a packing condition C2, a schedule condition C3, and an environmental condition C4. The article condition C1 is defined by at least one type of parameter including an article type Kg with respect to one or more articles 3 packed in the delivery box 2 as delivery target among, for example, the article type Kg, the initial packaging temperature, the outer shape, the outer size, the volume, the weight, the specific gravity, the specific heat, the thermal conductivity, the maximum allowable temperature (hereinafter, referred to as allowable temperature), and the material (in case of packaging article). FIG. 7 shows examples of the article type Kg, the specific gravity, the specific heat, and the thermal conductivity input to the cold storage analysis model Ma for each of the articles 3 as the article condition C1.

The packing condition C2 illustrated in FIG. 6 is defined by at least one type of parameter including the performance Xc of the cooling material capable of internally cooling the delivery box 2 for packing one or more articles 3 to be delivered (hereinafter, referred to as a cold insulator performance Xc) among, for example, the type (hereinafter, referred to as box type), the initial packing temperature, the material, the external shape, the external size, the thickness, the internal volume, the weight, the specific gravity, the specific heat, the thermal conductivity, the thermal insulation performance, the temperature change rate over time for each internal position, and the cold insulator performance Xc.

The schedule condition C3 is defined by at least one type of parameter including a target time tct that is a target of the cooling time tc, for one or more articles 3 to be delivered, among, for example, the target time tct, a scheduled delivery route Rd, and the like. The target time tct is set to include at least the scheduled delivery time corresponding to the scheduled delivery route Rd, among the scheduled delivery time, the average time from the completion of packing to the loading on the delivery vehicle 4 or the start of delivery, and the average time from the completion of delivery to the reception at the delivery destination β (see FIG. 1).

The environmental condition C4 is defined by at least one type of parameter including the cooling performance Yc of cooling the upper side of the bed 40 in the delivery vehicle 4 (hereinafter, referred to as cooling performance Yc), with respect to the delivery vehicle 4 that transports one or more articles 3 to be delivered as target article, among, for example, the vehicle type, the cooling performance Yc, and the predicted transition in temperature on the scheduled delivery route Rd. The predicted transition in temperature on the scheduled delivery route Rd is, for example, a transition of a temporal change predicted for at least one of the outside air temperature outside the delivery vehicle 4, the road surface temperature on which the delivery vehicle 4 is scheduled to travel, the space temperature on the cargo bed 40 in the delivery vehicle 4, and the like.

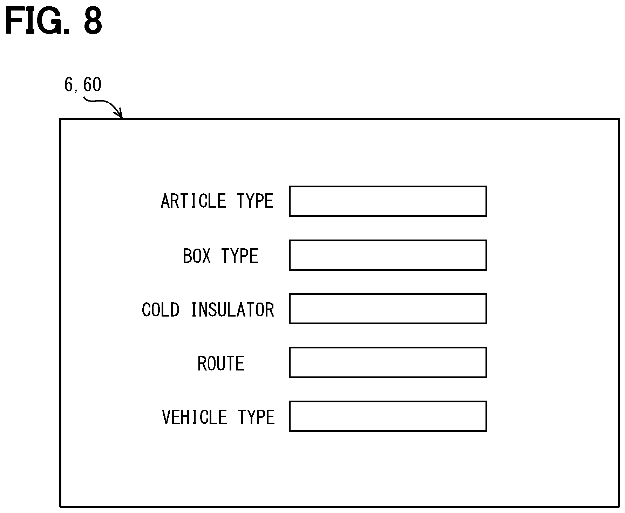

In S20 subsequent to S10 of the delivery support flow illustrated in FIG. 4, the input block 100 executes a process of inputting the delivery condition C to the cold insulation analysis model Ma. As the input processing of the delivery condition C in S20, manual input from the operator by the input unit 62 (hereinafter, simply referred to as operator input) may be executed. At this time, the input block 100 may cause the information presentation unit 60 to display an input reception image for receiving an operator input as illustrated in FIG. 8 to the operator. As the input process of the delivery condition C in S20, automatic input of a condition that is self-generated by the delivery support system 1 or transferred from the outside such as a delivery-related servicer and stored in the memory 70 may be executed (hereinafter, simply referred to as automatic input).

In S20, all the items of the article condition C1 may be input by the operator for one or more articles 3 to be delivered. In S20, when the article type Kg as the article condition C1 is input by the operator with respect to one or more articles 3 to be delivered, the other information of the article condition C1 may be automatically input to the cold insulation analysis model Ma by reading from the memory 70 (for example, in case of FIG. 8). In S20, all the items of the article condition C1 may be automatically input for one or more articles 3 to be delivered.

In S20, all the items of the packing condition C2 may be input by the operator with respect to the delivery box 2 in which at least one article 3 to be delivered is packed. In S20, when the box type and the cold insulator performance Xc as the packing condition C2 is input by the operator with respect to the delivery box 2 for packing at least one article 3 to be delivered, the other information of the packing condition C2 may be automatically input to the cold insulation analysis model Ma by being read from the memory 70 (for example, in case of FIG. 8). In S20, all the items of the packing condition C2 may be automatically input with respect to the delivery box 2 in which at least one article 3 to be delivered is packed.

In S20, all the items of the schedule condition C3 may be input by the operator for one or more articles 3 to be delivered. In S20, the scheduled delivery route Rd as the schedule condition C3 may be input by the operator with respect to one or more articles 3 to be delivered, and other information including the target time tct in the schedule condition C3 may be automatically input to the cold insulation analysis model Ma by being read from the memory 70 (for example, in the case of FIG. 8). In S20, all the items of the schedule condition C3 may be automatically input for one or more articles 3 to be delivered.

In S20, all the items of the environmental condition C4 may be input by the operator with respect to the delivery vehicle 4 that transports at least one article 3 to be delivered. In S20, the vehicle type as the environmental condition C4 may be input by the operator with respect to the delivery vehicle 4 that transports at least one article 3 to be delivered, and other information including the cooling performance Yc in the environmental condition C4 may be automatically input to the cold insulation analysis model Ma by being read from the memory 70 (for example, in case of FIG. 8). In S20, all the items of the environmental condition C4 may be automatically input with respect to the delivery vehicle 4 that transports at least one article 3 to be delivered. However, in any case, the predicted transition in temperature as the environmental condition C4 may be automatically set by the input block 100 based on the parameters Xc, tct, Rd, Yc, and the like input by the operator or automatically input as the condition C2, C3, C4 and automatically input to the cold insulation analysis model Ma.

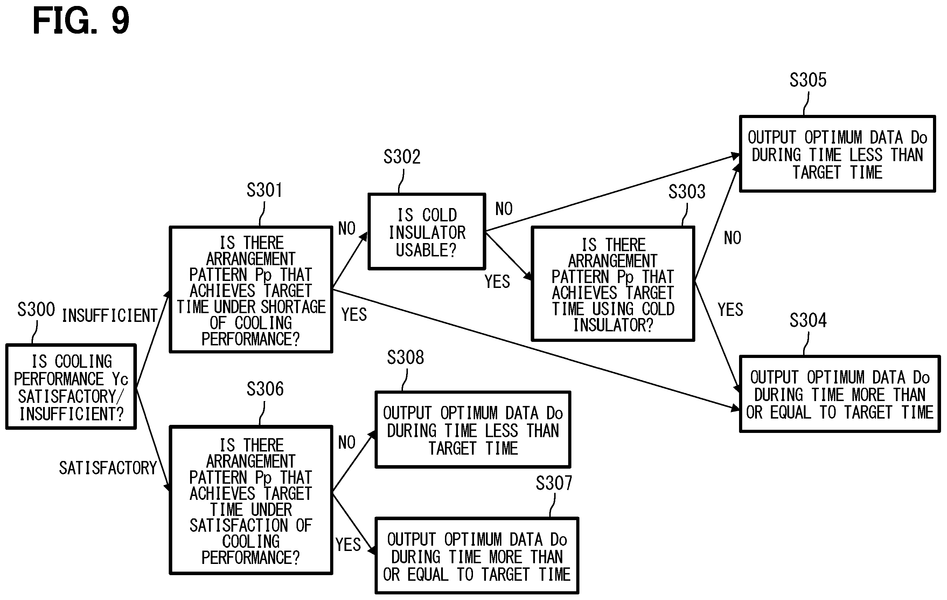

In S30 subsequent to S20 of the delivery support flow illustrated in FIG. 4, the output block 120 outputs the optimum data Do in which the cooling time tc and the arrangement pattern Pp are optimized by the cold insulation analysis model Ma to which the delivery condition C is input. Specifically, in S30, an optimization subroutine shown in FIG. 9 is executed.

In S300 of the optimization subroutine, the output block 120 determines whether the cooling performance Yc in the delivery vehicle 4 is satisfactory or insufficient for cooling. Specifically, any one of a satisfaction determination and an insufficiency determination is made in S300. The satisfaction determination represents that the cooling performance Yc on the cargo bed 40 in the delivery vehicle 4 is satisfied as the equipment performance for cooling the article 3 to the set temperature or less. The insufficiency determination represents that the cooling performance Yc is insufficient as the equipment performance. In the present embodiment, the satisfaction determination for the cooling performance Yc is made in the delivery vehicle 4 equipped with the cooling dedicated unit 41 (for example, the cold storage vehicle 4a), whereas the insufficiency determination for the cooling performance Yc is made in the delivery vehicle 4 without the cooling dedicated unit 41 (for example, the cargo van 4b, the cargo truck 4c, etc.).

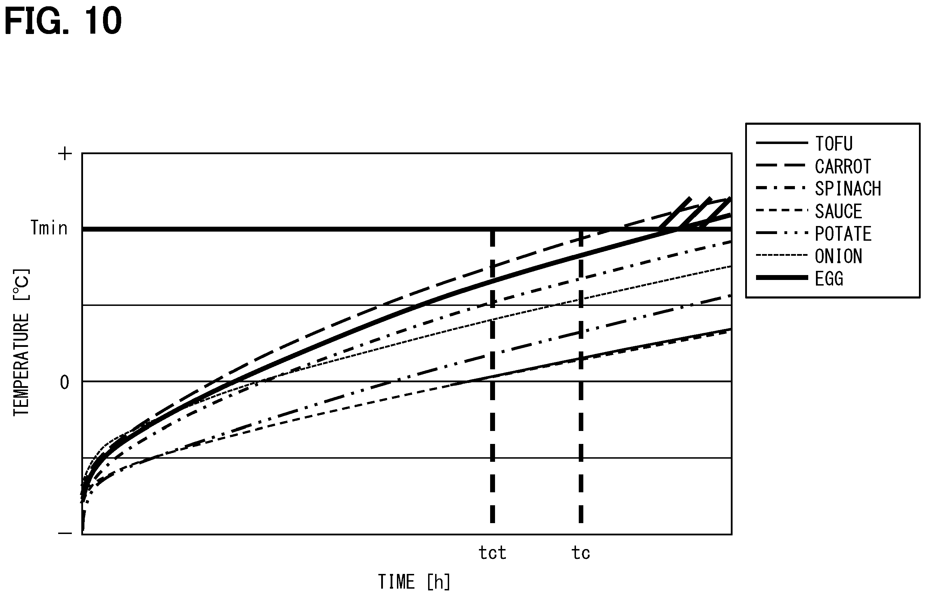

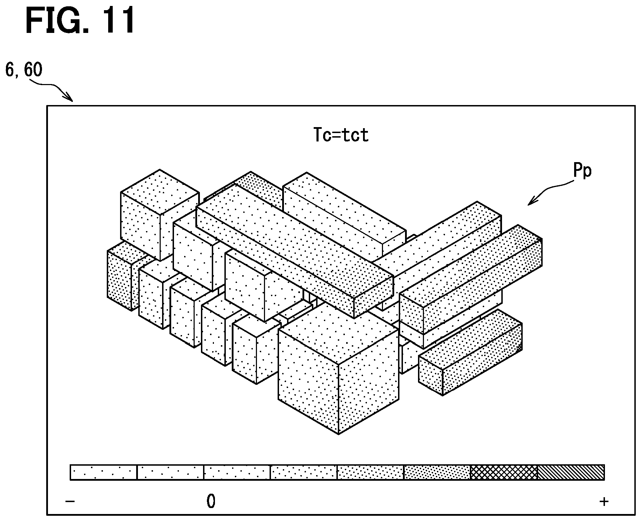

When the insufficiency determination is made in S300, the optimization subroutine proceeds to S301. In S301, the output block 120 determines the presence or absence of the arrangement pattern Pp that achieves the cooling time tc, which is longer than or equal to the target time tct, as the environmental condition C4 under the cooling performance Yc is insufficient, based on the optimum data Do output from the cold insulation analysis model Ma. FIG. 10 is a graph regarding the temperature change over time, and shows an example in which it is determined that the arrangement pattern Pp (see FIG. 5) is present (YES in S301). Specifically, the cooling time tc satisfying the minimum temperature Tmin is equal to or longer than the target time tct, among the allowable temperatures of the plural articles 3. With respect to the arrangement pattern Pp (see FIG. 5) when the presence determination is made (YES in S301), FIG. 11 schematically illustrates an example of thermal map representing the cooling temperature of each of the articles 3 with gray scale shading in a state where the cooling time tc reaches the target time tct. The absence determination (NO in S301) corresponds to a case where the presence of the arrangement pattern Pp that achieves the target time tct due to, for example, insufficiency of the cooling performance Yc is denied by the cold insulation analysis model Ma.

When the absence determination (NO) is made in S301 of FIG. 9, the optimization subroutine proceeds to S302. In S302, the output block 120 determines whether the cold insulator is usable. At this time, since the information on the usability of the cold insulator is included in the cold insulator performance Xc as the packing condition C2, the determination is made based on the usability information.

In case where a determination of YES is made in S302, the optimization subroutine proceeds to S303. In S303, the output block 120 determines, based on the optimum data Do output from the cold insulation analysis model Ma, whether or not there is an arrangement pattern Pp that achieves the cooling time tc, which is equal to or longer than the target time tct, using the cold insulator while the cooling performance Yc is insufficient as the environmental condition C4. The arrangement pattern Pp in the optimum data Do where the determination of YES is made includes the number of used cold insulators and the arrangement position optimized by the cold insulation analysis model Ma. A determination of NO corresponds to a case where the presence of the arrangement pattern Pp that achieves the target time tct even under the use of the maximum number of cold insulators is denied by the cold insulation analysis model Ma.

In the optimization subroutine, when a determination of YES is made in S301 or S303, the optimization subroutine proceeds to S304. In S304, the output block 120 outputs the optimum data Do of the arrangement pattern Pp in which the cooling time tc is the longest among the arrangement patterns Pp that achieve the target time tct while the cooling performance Yc is insufficient. At this time, the output block 120 may cause the information presentation unit 60 to display an optimized image presenting the arrangement pattern Pp in which the cooling time tc is the longest and equal to or longer than the target time tct as an output of the optimum data Do to the operator (in case where the operator is the same as the packing worker).

In the optimization subroutine, when a determination of NO is made in S302 or S303, the optimization subroutine proceeds to S305. In S305, the output block 120 outputs the optimum data Do of the arrangement pattern Pp in which the cooling time tc is the longest while being less than the target time tct among the arrangement patterns Pp due to the shortage of the cooling performance Yc. At this time, the output block 120 may cause the information presentation unit 60 to display, as an output of the optimum data Do, an optimized image presenting the arrangement pattern Pp in which the cooling time tc is less than the target time tct but the longest among the arrangement patterns Pp, to the operator (in case where the operator is the same as the packing worker).

When the satisfaction determination is made in S300, the optimization subroutine proceeds to S306. In S306, the output block 120 determines the presence or absence of the arrangement pattern Pp that achieves the cooling time tc equal to or longer than the target time tct under the satisfaction of the cooling performance Yc, based on the optimum data Do output from the cold insulation analysis model Ma. At this time, the optimum data Do when the presence determination is made (YES in S306) includes the cooling pattern Pc, in the delivery vehicle 4, optimized by the cold insulation analysis model Ma. The cooling pattern Pc is defined as, for example, a pattern obtained by optimizing the transition in the space temperature on the cargo bed 40, which is cooled and adjusted by the cooling dedicated unit 41, over the temporal change, by the cold insulation analysis model Ma based on the input of the predicted transition in temperature on the scheduled delivery route Rd. A determination of NO in S306 corresponds to a case where the presence of the arrangement pattern Pp that achieves the target time tct even under the satisfaction of the cooling performance Yc is denied by the cold insulation analysis model Ma.

When a determination of YES is made in S306, the optimization subroutine proceeds to S307. In S307, the output block 120 outputs the optimum data Do of the arrangement pattern Pp in which the cooling time tc is the longest among the arrangement patterns Pp in which the target time tct is achieved under the satisfaction of the cooling performance Yc. At this time, the output block 120 may cause the information presentation unit 60 to display an optimized image presenting the arrangement pattern Pp in which the cooling time tc is the longest and equal to or longer than the target time tct as an output of the optimum data Do to the operator (in case where the operator is the same as the packing worker). At this time, the output block 120 may present the cooling pattern Pc corresponding to the arrangement pattern Pp in which the cooling time tc is equal to or longer than the target time tct and is the longest by displaying the optimized image.

When a determination of NO is made in S306, the optimization subroutine proceeds to S308. In S308, the output block 120 outputs the optimum data Do of the arrangement pattern Pp in which the cooling time tc is the longest among the arrangement patterns Pp in which the cooling time tc is less than the target time tct even when the cooling performance Yc is satisfied. At this time, the output block 120 may cause the information presentation unit 60 to display, as an output of the optimum data Do, an optimized image presenting the arrangement pattern Pp in which the cooling time tc is less than the target time tct but the longest among the arrangement patterns Pp, to the operator (in case where the operator is the same as the packing worker). In addition, at this time, the output block 120 may present the cooling pattern Pc corresponding to the arrangement pattern Pp in which the cooling time tc is less than the target time tct but the longest by displaying the optimized image.

In the optimization subroutine, in S307, the output block 120 may output the optimum data Do of the cooling pattern Pc that minimizes the cooling energy predicted to be consumed in the temperature adjustment according to the cooling performance Yc, with respect to the arrangement pattern Pp in which the cooling time Tc is equal to or longer than the target time tct. In S308, the output block 120 may output the optimum data Do of the cooling pattern Pc that minimizes the cooling energy predicted to be consumed in the temperature adjustment according to the cooling performance Yc, with respect to the arrangement pattern Pp in which the cooling time Tc is less than the target time tct. At this time, the output block 120 may present not only the transition of the temperature adjustment according to the cooling performance Yc but also, for example, the cooling start timing or the like as the cooling pattern Pc by displaying the optimized image.

In S304, S305, S307, and S308 of the optimization subroutine, a three-dimensional image as illustrated in FIG. 5 or 11 may be displayed and output as an optimized image. In S304, S305, S307, and S308 of the optimization subroutine, a thermal map image of the cold storage temperature as illustrated in FIG. 11 may be displayed and output as an optimized image. In S304, S305, S307, and S308 of the optimization subroutine, in addition to or instead of the optimized image, the optimum data Do representing the arrangement pattern Pp as a character string may be displayed and output.

Further, in S304, S305, S307, and S308 of the optimization subroutine, the optimum data Do may be output to an external delivery-related servicer, and may be utilized for, for example, development or improvement of a delivery-related service. In S304, S305, S307, and S308 of the optimization subroutine, at least the arrangement pattern Pp of the optimum data Do may be output to the control unit of the packing robot that automatically packs the articles 3 to be used for the automatic packing. In S307 and S308 of the optimization subroutine, at least the cooling pattern Pc of the optimum data Do may be output to the control unit of the delivery vehicle 4 to be used for the automatic cooling control during delivery.

The current execution of the optimization subroutine according to FIG. 9 described so far is ended by the completion of the execution of any one of S304, S305, S307, and S308, so that the current execution of the delivery support flow according to FIG. 4 is also ended.

The effects and advantages in the present embodiment will be explained below.

According to the present embodiment, the cold insulation analysis model Ma for analyzing the cooling time tc according to the arrangement pattern Pp of the articles 3 in the delivery box 2 is read from the memory 70. Therefore, in the present embodiment, the optimum data Do obtained by optimizing the cooling time tc and the arrangement pattern Pp is output by the cold insulation analysis model Ma to which the delivery condition C of the article 3 is input. Accordingly, since the cooling time tc and the arrangement pattern Pp that influence the cooling power can be determined based on the output optimum data Do, it is possible to secure the cooling power necessary for the delivery.

According to the present embodiment, the optimum data Do of the arrangement pattern Pp that achieves the target time tct is output by the cold storage analysis model Ma, while the target time tct is a target of the cooling time tc input as the delivery condition C. Accordingly, the arrangement pattern Pp that provides the cooling power necessary for the target time tct can be determined based on the output optimum data Do. Therefore, it is possible to secure the necessary cooling power for achieving the target time tct.

According to the present embodiment, the optimum data Do of the arrangement pattern Pp in which the cooling time tc is the longest among the arrangement patterns Pp that achieve the target time tct is output. Accordingly, not only the target time tct is achieved, but also the arrangement pattern Pp that maximizes the cooling time tc can be determined based on the output optimum data Do. Therefore, the cooling power for achieving the target time tct can be secured on the safe side.

According to the present embodiment, when the presence of the arrangement pattern Pp that achieves the target time tct is denied by the cold insulation analysis model Ma, the optimum data Do of the arrangement pattern Pp in which the cooling time tc is the longest while being less than the target time tct is output. Accordingly, for the delivery condition C in which only the arrangement pattern Pp that gives the cooling time tc less than the target time tct is present, the arrangement pattern Pp for securing the cooling power to the maximum can be determined based on the output optimum data Do. Therefore, the cooling power can be adjusted according to the delivery condition C.

According to the present embodiment, the optimum data Do obtained by optimizing the cooling pattern Pc in the delivery vehicle 4 together with the cooling time tc and the arrangement pattern Pp by the cold insulation analysis model Ma is output, while the cooling performance Yc in the delivery vehicle 4 is input as the delivery condition C. Accordingly, the arrangement pattern Pp capable of increasing the cooling time tc by optimizing the cooling pattern Pc depending on the cooling performance Yc can be determined based on the output optimum data Do. Therefore, it is possible to secure a high cooling power by utilizing the cooling performance Yc.

According to the present embodiment, the optimum data Do obtained by optimizing the cooling pattern Pc is output by the cold insulation analysis model Ma, while the predicted transition in temperature on the delivery scheduled route Rd of the delivery vehicle 4 is input as the delivery condition C together with the cooling performance Yc. Accordingly, the arrangement pattern Pp capable of increasing the cooling time tc by matching the cooling pattern Pc depending on the cooling performance Yc with the predicted transition in temperature to the scheduled delivery route Rd can be determined based on the output optimum data Do. Therefore, it is possible to secure an appropriate cooling power in consideration of the transition in temperature on the scheduled delivery route Rd.

According to the present embodiment, the optimum data Do of the cooling time tc and the arrangement pattern Pp in the cooling pattern Pc that minimizes the cooling energy is output. Accordingly, the cooling time tc and the arrangement pattern Pp capable of securing the necessary cooling power even when the cooling energy is the minimum can be determined based on the output optimum data Do. Therefore, it is possible to achieve both saving of energy and securing of cooling power.

According to the present embodiment, the optimum data Do obtained by optimizing the number of cold insulators used together with the cooling time tc and the arrangement pattern Pp is output by the cold insulation analysis model Ma, while the cooling performance Yc insufficient for cold insulation is input as the delivery condition C. Accordingly, even in a case where the cooling performance Yc is insufficient for the cold insulation, the cooling time tc and the arrangement pattern Pp capable of securing the necessary cold insulation power by using the necessary minimum cold insulation material can be determined based on the output optimum data Do. Therefore, it is possible to achieve a balance between the cold insulation property and the circular economy property.

In a modification, the control computer 7 of the delivery support system 1 may include at least one of a digital circuit and an analog circuit as a processor. In particular, the digital circuit is at least one type of, for example, an ASIC (Application Specific Integrated Circuit), a FPGA (Field Programmable Gate Array), an SOC (System on a Chip), a PGA (Programmable Gate Array), a CPLD (Complex Programmable Logic Device), and the like. Such a digital circuit may include a memory in which a program is stored.

At least one of the parameters constituting the delivery condition C of the modification, excluding the article type Kg as the article condition C1 and the target time tct as the schedule condition C3, may be incorporated in the construction stage or the learning stage of the cold insulation analysis model Ma. At least one of the packing condition C2 and the environmental condition C4 may be omitted as the delivery condition C of the modification. Further, in this modification, at least one of the packing condition C2 and the environmental condition C4 may be incorporated in the construction stage or the learning stage of the cold insulation analysis model Ma.

In the optimization subroutine of the modification, the execution of at least S300, S302, or S303 may be skipped among S300 to S305. In this modification, the cold insulator performance Xc may be omitted as the packing condition C2. In the optimization subroutine of the modification, the execution of S300 and S306 to S308 may be skipped. In this modification, the cooling performance Yc may be omitted as the environmental condition C4. In the optimization subroutine of the modification, the arrangement pattern Pp in which the cooling time tc is other than the longest in S304, S305, S307, S308 may be output as the optimum data Do in addition to or instead of the arrangement pattern Pp in which the cooling time tc is the longest.

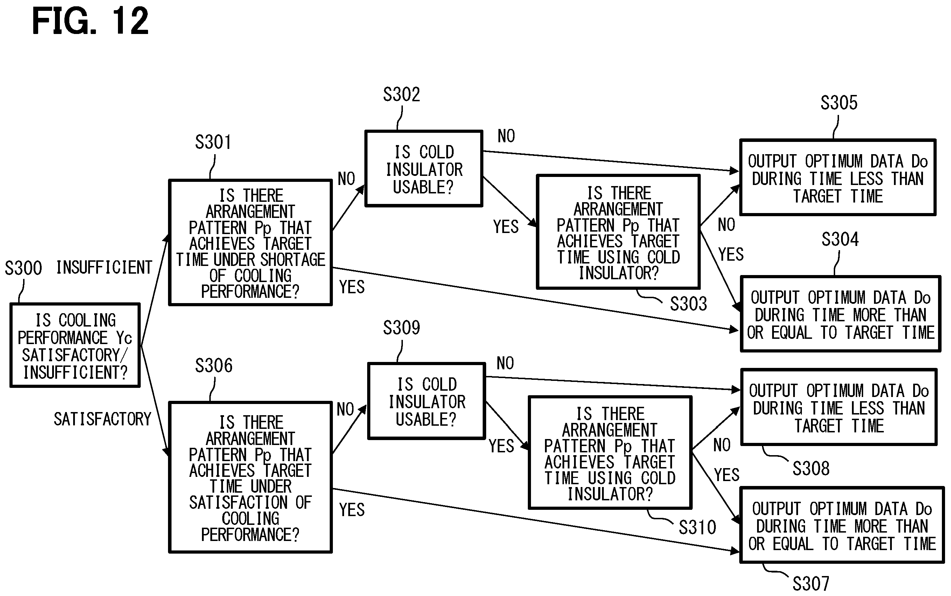

As illustrated in FIG. 12, in the optimization subroutine according to the modification, S309 corresponding to S302 may be executed when the determination of NO is made in S306. S310 corresponding to S303 may be executed when the determination of NO is made in S309. However, in this modification, in S310, it is determined whether or not there is an arrangement pattern Pp that requires the use of a cold insulator in order to achieve the cooling time tc equal to or longer than the target time tct although the cooling performance Yc for cold insulation is satisfied. Therefore, when the determination of YES is made in S306 or S310, the optimization subroutine proceeds to S307. When the determination of NO is made in S309 or S310, the optimization subroutine proceeds to S308.

In the embodiment and the modifications, a control device (for example, a control ECU or the like) or a semiconductor device (for example, a semiconductor chip or the like) may be used as a device including the processor 72 and the memory 70.

## Claims

1. A delivery support method executed by a processor (72) and a storage medium (70) to support a delivery process by a delivery vehicle (4) for articles (3) that needs to be kept cool in a delivery box (2), the method comprising:
reading a cold insulation analysis model (Ma) from the storage medium to analyze a cooling time (tc) according to an arrangement pattern (Pp) of the articles in the delivery box; and
outputting optimum data (Do) in which the cooling time and the arrangement pattern are optimized by the cold insulation analysis model to which a delivery condition (C) of the article is input, wherein
the outputting of the optimum data includes
outputting the optimum data of the arrangement pattern that achieves a target time (tct) that is a target of the cooling time by the cold insulation analysis model in which the target time is input as the delivery condition.

2. The delivery support method according to claim 1, wherein
the outputting of the optimum data includes
outputting the optimum data of the arrangement pattern in which the cooling time is longest, of the arrangement pattern that achieves the target time.

3. The delivery support method according to claim 1 or 2, wherein
the outputting of the optimum data includes
outputting the optimum data of the arrangement pattern in which the cooling time is longest and less than the target time, when a presence of the arrangement pattern that achieves the target time is denied by the cold insulation analysis model.

4. The delivery support method according to any one of claims 1 to 3, wherein
the outputting of the optimum data includes
outputting the optimum data optimized in a cooling pattern (Pc) inside the delivery vehicle together with the cooling time and the arrangement pattern by the cold insulation analysis model in which a cooling performance (Yc) inside the delivery vehicle is input as the delivery condition.

5. The delivery support method according to claim 4, wherein
the outputting of the optimum data includes
outputting the optimum data optimized in the cooling pattern by the cold insulation analysis model in which a predicted transition in temperature on a delivery scheduled route (Rd) of the delivery vehicle is input as the delivery condition together with the cooling performance.

6. The delivery support method according to claim 4 or 5, wherein
the outputting of the optimum data includes
outputting the optimum data of the cooling time and the arrangement pattern with the cooling pattern that minimizes a cooling energy.

7. The delivery support method according to any one of claims 4 to 6, wherein
the outputting of the optimum data includes
outputting the optimum data optimized in a number of cold insulators together with the cooling time and the arrangement pattern by the cold insulation analysis model in which the cooling performance, which is insufficient for cooling, is input as the delivery condition.

8. A delivery support system including a storage medium (70) and a processor (72) to support a delivery process by a delivery vehicle (4) for an article (3) that needs to be kept cool in a delivery box (2), wherein
the processor is configured to execute:
reading a cold insulation analysis model (Ma) from the storage medium to analyze a cooling time (tc) according to an arrangement pattern (Pp) of the article in the delivery box; and
outputting optimum data (Do) optimized in the cooling time and the arrangement pattern by the cold insulation analysis model to which a delivery condition (C) of the article is input, wherein
the outputting of the optimum data includes
outputting the optimum data of the arrangement pattern that achieves a target time (tct) that is a target of the cooling time by the cold insulation analysis model in which the target time is input as the delivery condition.

9. A delivery support program stored in a storage medium (70) and including instructions executed by a processor (72) to support a delivery process by a delivery vehicle (4) for an article (3) that needs to be kept cool in a delivery box (2), wherein
the instructions include:
reading a cold insulation analysis model (Ma) from the storage medium to analyze a cooling time (tc) according to an arrangement pattern (Pp) of the article in the delivery box; and
outputting optimum data (Do) optimized in the cooling time and the arrangement pattern by the cold insulation analysis model to which a delivery condition (C) of the article is input, wherein
the outputting of the optimum data includes
outputting the optimum data of the arrangement pattern that achieves a target time (tct) that is a target of the cooling time by the cold insulation analysis model in which the target time is input as the delivery condition.

## Patentansprüche

1. Ein von einem Prozessor (72) und einem Speichermedium (70) ausgeführtes Lieferungsunterstützungsverfahren zur Unterstützung eines Lieferungsprozesses durch ein Lieferungsfahrzeug (4) für Artikel (3), die in einem Lieferungskasten (2) gekühlt gehalten werden müssen, wobei das Verfahren aufweist:
Auslesen eines Kälteisolations-Analysemodells (Ma) aus dem Speichermedium zur Analyse einer Abkühlzeit (tc) entsprechend einem Anordnungsmuster (Pp) der Artikel im Lieferungskasten; und
Ausgeben optimaler Daten (Do), in denen die Kühlzeit und das Anordnungsmuster durch das Kälteisolations-Analysemodell, in das eine Lieferbedingung (C) des Artikels eingegeben wird, optimiert sind, wobei
das Ausgeben der optimalen Daten enthält:
Ausgeben der optimalen Daten des Anordnungsmusters, das eine Sollzeit (tct) erreicht, die ein Soll der Kühlzeit durch das Kälteisolations-Analysemodell ist, in das die Sollzeit als Lieferbedingung eingegeben wird.

2. Lieferungsunterstützungsverfahren nach Anspruch 1, wobei
das Ausgeben der optimalen Daten enthält:
Ausgeben der optimalen Daten des Anordnungsmusters, bei dem die Kühlzeit am längsten ist, des Anordnungsmusters, das die Sollzeit erreicht.

3. Lieferungsunterstützungsverfahren nach Anspruch 1 oder 2, wobei
das Ausgeben der optimalen Daten enthält:
Ausgeben der optimalen Daten des Anordnungsmusters, bei dem die Abkühlzeit am längsten ist und unter der Sollzeit liegt, wenn ein Vorhandensein des Anordnungsmusters, mit dem die Sollzeit erreicht wird, durch das Kälteisolations-Analysemodell verneint wird.

4. Lieferungsunterstützungsverfahren nach einem der Ansprüche 1 bis 3, wobei
das Ausgeben der optimalen Daten enthält:
Ausgeben der optimalen Daten optimiert in einem Kühlmuster (Pc) innerhalb des Lieferungsfahrzeugs zusammen mit der Kühlzeit und dem Anordnungsmuster durch das Kälteisolations-Analysemodell, in das eine Kühlleistung (Yc) innerhalb des Lieferungsfahrzeugs als Lieferbedingung eingegeben wird.

5. Lieferungsunterstützungsverfahren nach Anspruch 4, wobei
das Ausgeben der optimalen Daten enthält:
Ausgeben der im Kühlmuster optimierten Daten durch das Kälteisolations-Analysemodell, in das ein vorhergesagter Temperaturübergang auf einer geplanten Lieferroute (Rd) des Lieferungsfahrzeugs als die Lieferbedingung zusammen mit der Kühlleistung eingegeben wird.

6. Lieferungsunterstützungsverfahren nach Anspruch 4 oder 5, wobei
das Ausgeben der optimalen Daten enthält:
Ausgeben der optimalen Daten der Kühlzeit und des Anordnungsmusters mit dem Kühlmuster, das eine Kühlenergie minimiert.

7. Lieferungsunterstützungsverfahren nach einem der Ansprüche 4 bis 6, wobei
das Ausgeben der optimalen Daten enthält:
Ausgeben der in einer Anzahl von Kälteisolatoren optimierten optimalen Daten zusammen mit der Kühlzeit und dem Anordnungsmuster durch das Kälteisolations-Analysemodell, in das die zur Kühlung unzureichende Kühlleistung als die Lieferbedingung eingegeben wird.

8. Lieferungsunterstützungssystem mit einem Speichermedium (70) und einem Prozessor (72) zur Unterstützung eines Lieferungsprozesses durch ein Lieferungsfahrzeug (4) für einen Artikel (3), der in einem Lieferungskasten (2) gekühlt gehalten werden muss, wobei
der Prozessor ausgelegt ist, folgendes auszuführen:
Auslesen eines Kälteisolations-Analysemodells (Ma) aus dem Speichermedium zur Analyse einer Kühlzeit (tc) entsprechend einem Anordnungsmuster (Pp) des Artikels im Lieferungskasten; und
Ausgeben optimaler Daten (Do), die in der Kühlzeit und dem Anordnungsmuster durch das Kälteisolations-Analysemodell, in das eine Lieferbedingung (C) des Artikels eingegeben wird, optimiert sind, wobei
das Ausgeben der optimalen Daten enthält:
Ausgeben der optimalen Daten des Anordnungsmusters, das eine Sollzeit (tct) erreicht, die ein Soll der Kühlzeit durch das Kälteisolations-Analysemodell ist, in das die Sollzeit als Lieferbedingung eingegeben wird.

9. Lieferungsunterstützungsprogramm, das in einem Speichermedium (70) gespeichert ist und Anweisungen enthält, die von einem Prozessor (72) ausgeführt werden, um einen Lieferungsprozess durch ein Lieferungsfahrzeug (4) für einen Artikel (3) zu unterstützen, der in einem Lieferungskasten (2) gekühlt gehalten werden muss, wobei die Anweisungen enthalten:
Auslesen eines Kälteisolations-Analysemodells (Ma) aus dem Speichermedium zur Analyse einer Kühlzeit (tc) entsprechend einem Anordnungsmuster (Pp) des Artikels im Lieferungskasten; und
Ausgeben optimaler Daten (Do), die in der Kühlzeit und dem Anordnungsmuster durch das Kälteisolations-Analysemodell, in das eine Lieferbedingung (C) des Artikels eingegeben wird, optimiert sind, wobei
das Ausgeben der optimalen Daten enthält:
Ausgeben der optimalen Daten des Anordnungsmusters, das eine Sollzeit (tct) erreicht, die ein Soll der Kühlzeit durch das Kälteisolations-Analysemodell ist, in das die Sollzeit als Lieferbedingung eingegeben wird.

## Revendications

1. Procédé de prise en charge de livraison exécuté par un processeur (72) et un support de stockage (70) pour prendre en charge un processus de livraison par un véhicule de livraison (4) pour des articles (3) qui doivent être conservés au froid dans une boîte de livraison (2), le procédé comprenant :
la lecture d'un modèle d'analyse d'isolation au froid (Ma) à partir du support de stockage pour analyser un temps de refroidissement (tc) selon un type d'agencement (Pp) des articles dans la boîte de livraison ; et
la sortie de données optimales (Do) dans lesquelles le temps de refroidissement et le type d'agencement sont optimisés par le modèle d'analyse d'isolation au froid dans lequel une condition de livraison (C) de l'article est entrée, dans lequel
la sortie des données optimales inclut
la sortie des données optimales du type d'agencement qui atteint un temps cible (tct) qui est une cible du temps de refroidissement par le modèle d'analyse d'isolation au froid dans lequel le temps cible est entré comme condition de livraison.

2. Procédé de prise en charge de livraison selon la revendication 1, dans lequel
la sortie des données optimales inclut
la sortie des données optimales du type d'agencement dans lequel le temps de refroidissement est le plus long du type d'agencement qui atteint le temps cible.

3. Procédé de prise en charge de livraison selon la revendication 1 ou 2, dans lequel
la sortie des données optimales inclut
la sortie des données optimales du type d'agencement dans lequel le temps de refroidissement est le plus long et inférieur au temps cible, lorsqu'une présence du type d'agencement qui atteint le temps cible est refusée par le modèle d'analyse d'isolation au froid.

4. Procédé de prise en charge de livraison selon l'une quelconque des revendications 1 à 3, dans lequel
la sortie des données optimales inclut
la sortie des données optimales optimisées dans un type de refroidissement (Pc) à l'intérieur du véhicule de livraison conjointement avec le temps de refroidissement et le type d'agencement par le modèle d'analyse d'isolation au froid dans lequel une performance de refroidissement (Yc) à l'intérieur du véhicule de livraison est entrée comme condition de livraison.

5. Procédé de prise en charge de livraison selon la revendication 4, dans lequel
la sortie des données optimales inclut
la sortie des données optimales optimisées dans un type de refroidissement par le modèle d'analyse d'isolation au froid dans lequel une transition de température prédite sur un itinéraire de livraison prévu (Rd) du véhicule de livraison est entrée comme condition de livraison conjointement avec la performance de refroidissement.

6. Procédé de prise en charge de livraison selon la revendication 4 ou 5, dans lequel
la sortie des données optimales inclut
la sortie des données optimales du temps de refroidissement et du type d'agencement avec le type de refroidissement qui réduit au minimum une énergie de refroidissement.

7. Procédé de prise en charge de livraison selon l'une quelconque des revendications 4 à 6, dans lequel
la sortie des données optimales inclut
la sortie des données optimales optimisées dans un nombre d'isolateurs au froid conjointement avec le temps de refroidissement et le type d'agencement par le modèle d'analyse d'isolation au froid dans lequel la performance de refroidissement, qui est insuffisante pour le refroidissement, est entrée comme condition de livraison.

8. Système de prise en charge de livraison incluant un support de stockage (70) et un processeur (72) pour prendre en charge un processus de livraison par un véhicule de livraison (4) pour un article (3) qui doit être conservé au froid dans une boîte de livraison (2), dans lequel
le processeur est configuré pour exécuter :
la lecture d'un modèle d'analyse d'isolation au froid (Ma) à partir du support de stockage pour analyser un temps de refroidissement (tc) selon un type d'agencement (Pp) de l'article dans la boîte de livraison ; et
la sortie de données optimales (Do) optimisées dans le temps de refroidissement et le type d'agencement par le modèle d'analyse d'isolation au froid dans lequel une condition de livraison (C) de l'article est entrée, dans lequel
la sortie des données optimales inclut
la sortie des données optimales du type d'agencement qui atteint un temps cible (tct) qui est une cible du temps de refroidissement par le modèle d'analyse d'isolation au froid dans lequel le temps cible est entré comme condition de livraison.

9. Programme de prise en charge de livraison stocké dans un support de stockage (70) et incluant des instructions exécutées par un processeur (72) pour prendre en charge un processus de livraison par un véhicule de livraison (4) pour un article (3) qui doit être conservé au froid dans une boîte de livraison (2), dans lequel
les instructions incluent :
la lecture d'un modèle d'analyse d'isolation au froid (Ma) à partir du support de stockage pour analyser un temps de refroidissement (tc) selon un type d'agencement (Pp) de l'article dans la boîte de livraison ; et
la sortie de données optimales (Do) optimisées dans le temps de refroidissement et le type d'agencement par le modèle d'analyse d'isolation au froid dans lequel une condition de livraison (C) de l'article est entrée, dans lequel
la sortie des données optimales inclut
la sortie des données optimales du type d'agencement qui atteint un temps cible (tct) qui est une cible du temps de refroidissement par le modèle d'analyse d'isolation au froid dans lequel le temps cible est entré comme condition de livraison.
